# EUROPEAN PATENT APPLICATION

(11) **EP 3 442 125 A1**
(43) Date of publication of application: **13.02.2019**
(21) Application number: 17185787.3
(22) Date of filing: 10.08.2017
(51) Int. Cl.: H03M 7/30

(54) **SENSOR NETWORK ASSEMBLY FOR REDUCING QUANTITY OF DATA FOR VEHICLES**

(71) Applicant: Continental Automotive GmbH, 30165 Hannover (DE)
(72) Inventor: Shankar Kudana, Arun, 560073 Bangalore, Karnataka (IN); Chokkarapu, Anil, 506001 Hanamkonda, Warngal (IN); Asvatha Narayanan, Vishnu Vardhana, 560037 Kundanahalli (IN); Gomathinayagam, Murugan, 560068 BTM Layout I Stage (IN); Agarwal, Mukul, 211016 Allahabad (IN)
(74) Representative: Reuter, Andreas

(57) **Abstract**

The present invention relates to a sensor network assembly (100) for reducing data for vehicles, the device (100) comprising: a data analysis module (400), which is configured to perform data analysis of provided data; at least one sensor (101, 102, 103), which is configured to provide a data stream; a data compressor (101A, 102A, 103A), which is coupled to the at least one sensor (101, 102, 103) and which is configured to compress at least one data stream to provide at least one compressed data stream; and a data decompressor (401A), which is coupled to a data analysis module and which is configured to decompress the least one compressed data stream.

## Description

### FIELD OF THE INVENTION

The present invention relates to the field of data transmission and data analysis for vehicles. Particularly, the present invention relates to a sensor network assembly for reducing the quantity of data for a vehicle.

### BACKGROUND OF THE INVENTION

Current vehicles comprise of active and passive safety systems having multiple sensors integrated with it.

The networks of sensors along with the assisted driving control unit, ADCU, are used to build a comprehensive representation of the environment around the vehicle and the interaction of the vehicle with any surroundings and take necessary actions in critical situations to make driving safer.

The type and number of sensors, for instance multiple cameras, further multiple light detection and ranging, abbreviated LIDAR, sensors, or multiple radar sensors and ultrasound based sensors leads to increased amounts of data.

Further also the data resolution of each sensor in the vehicle are increasing with every new generation of sensors leading to larger and larger data volumes to be stored and to be processed.

These sensors generate huge amount of data inducing bandwidth constraints restricting the amount of data that can be transmitted within the vehicle network for communication or over wireless channel for V2X communication. This further also implies limited data storage capacity on vehicle and on cloud.

### SUMMARY OF THE INVENTION

There may be a need to improve and reduce the data quantity to be stored and/or to be processed for a vehicle.

These needs are met by the subject matter of the independent claims. Further exemplary embodiments are evident from the dependent claims and the following description.

An aspect of the present invention relates to a sensor network assembly for reducing quantity of data for a vehicle, the sensor network assembly comprising:
- a data analysis module, which is configured to perform data analysis of input data;
- at least one sensor, which is configured to provide at least one data stream;
- a data compressor, which is coupled to the at least one sensor and which is configured to compress the at least one data stream to provide at least one compressed data stream;
- a data decompressor, which is coupled to the data analysis module and which is configured to decompress the least one compressed data stream to provide the input data.

The present sensor network assembly for reducing quantity of data for vehicles advantageously provides compression and decompression modules incorporated to the existing network-of-sensors.

The present sensor network assembly for reducing quantity of data for vehicles advantageously makes use of well-known lossless and lossy data compression techniques based on use case.

The term "lossy data compression" as used by the present invention may be define lossy compression or irreversible compression that is the class of data encoding methods that uses inexact approximations and partial data discarding to represent the content. Well-designed lossy compression technology often reduces file sizes significantly before degradation is noticed by the end-user.

The proposed sensor network assembly for reducing quantity of data for vehicles advantageously is applicable for camera, radar, lidar or LiDAR - considered an acronym of Light Detection and Ranging - or ultrasonic images coming out of respective sensors.

The present sensor network assembly for reducing quantity of data for vehicles advantageously is applicable for data and/or image visualizations on human-machine-interface, HMI, display devices.

The present sensor network assembly for reducing quantity of data for vehicles provides a scalable architecture, which can work independently of the number and/or type of sensors used by the system.

A further, second aspect of the present invention relates to a sensor network assembly for reducing quantity of data for a vehicle, the sensor network assembly comprising:
- a data analysis module, which is configured to perform data analysis of input data;
- a data recording module, which is configured to perform recording of data;
- at least one sensor, which is configured to provide a data stream;
- a data compressor, which is coupled to the at least one sensor module and which is configured to compress at least one data stream to provide at least one compressed data stream prior to the recording of the data; and
- a data decompressor, which is coupled to a data analysis module and which is configured to decompress the least one compressed data stream.

A further, third aspect of the present invention relates to a method for reducing quantity of data for vehicles, the method comprising the following steps of:
- Providing a data stream by means of at least one sensor;
- Compressing the at least one data stream to provide at least one compressed data stream by means of a data compressor, which is coupled to the recording module instead within the sensors; and
- Decompressing the least one compressed data stream by means of a data decompressor, which is coupled to a data analysis module of a sensor network assembly.

According to an exemplary embodiment of the present invention, wherein the data compressor is configured to compress the at least one data stream by removing spatial redundancy and/or temporal redundancy of the least one data stream.

According to an exemplary embodiment of the present invention, the sensor network assembly is configured to route the at least one compressed data stream through a vehicle based on:
- online-data-streaming for visualizing the at least one compressed data stream on a driver dash-board; and/or
- offline-data-streaming to a data storage of car black-box and/or to data-recording-unit of the car; and/or- over-the-air transmission of the at least one compressed data stream for performing cloud-based data-analytics of the at least one compressed data stream.

According to an exemplary embodiment of the present invention, the data decompressor is configured to decompress the least one compressed data stream based on:
- online-data-streaming:
   i) for visualizing data on a human-machine-interface device or on driver dash-board; and/or
   ii) for processing of the least one compressed data stream on an assisted driving control unit after decompress the compressed data; and/or
- offline-data-streaming:
   i) for reducing bandwidth consumption.

According to an exemplary embodiment of the present invention, the data compressor is configured to support:
- lossless compression modes; and/or
- lossy compression modes.

According to an exemplary embodiment of the present invention, the data compressor is configured to switch between the supported lossless compression modes and the lossy compression modes based on an operation scenario.

According to an exemplary embodiment of the present invention, the sensor network assembly is configured to be scalable to any number of sensors integrated into vehicle.

A computer program performing the method of the present invention may be stored on a computer-readable medium. A computer-readable medium may be a floppy disk, a hard disk, a CD, a DVD, an USB (Universal Serial Bus) storage device, a RAM (Random Access Memory), a ROM (Read Only Memory) or an EPROM (Erasable Programmable Read Only Memory).

A computer-readable medium may also be a data communication network, for example the Internet, which allows downloading a program code.

The methods, systems, and devices described herein may be implemented as software in a Digital Signal Processor, DSP, in a micro-controller or in any other side-processor or as a hardware circuit within an application specific integrated circuit, ASIC, CPLD or FPGA.

The present invention can be implemented in digital electronic circuitry or in computer hardware, firmware, software, or in combinations thereof, for instance in available hardware of conventional medical imaging devices or in new hardware dedicated for processing the methods described herein.

### BRIEF DESCRIPTION OF THE DRAWINGS

A more complete appreciation of the invention and the attendant advantages thereof will be clearly understood by reference to the following schematic drawings, which are not to scale, wherein:
- Fig. 1: shows a schematic flowchart diagram for a method for reducing the quantity of data for a vehicle according to an exemplary embodiment of the present invention;
- Fig. 2: shows a schematic diagram for existing network sensor assembly without reducing the quantity of data for a vehicle for explaining the present invention;
- Fig. 3: shows a schematic diagram for a network sensor assembly for reducing the quantity of data for a vehicle according to an exemplary embodiment of the present invention;
- Fig. 4: shows a schematic diagram for a network sensor assembly for reducing the quantity of data for a vehicle according to an exemplary embodiment of the present invention;
- Fig. 5: shows an example Bayer pattern according to an exemplary embodiment of the present invention;
- Fig. 6: shows a schematic diagram of data rearrangement in YUV 4:2:2 chromo sampling according to an exemplary embodiment of the present invention;
- Fig. 7: shows a schematic diagram of a coding schema inside codec according to an exemplary embodiment of the present invention; and
- Fig. 8: shows a schematic diagram of results for a percentage reduction in size according to an exemplary embodiment of the present invention.

### DETAILED DESCRIPTION OF EMBODIMENTS

The illustration in the drawings is purely schematic and does not intend to provide scaling relations or size information. In different drawings, similar or identical elements are provided with the same reference numerals.

Generally, identical parts, units, entities or steps are provided with the same reference symbols in the description.

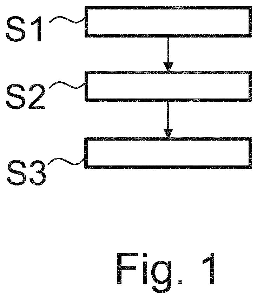

Fig. 1 shows a schematic flowchart diagram for a method for reducing the quantity of data for a vehicle according to an exemplary embodiment of the present invention.

The method for reducing quantity of data for vehicles comprises the following steps:
As a first step of the method, providing S1 a data stream by means of at least one sensor 101, 102, 103 is performed.

As a second step of the method, compressing S2 the at least one data stream to provide at least one compressed data stream is performed by means of a data compressor 101A, 102A, 103A, which is coupled to the at least one sensor 101, 102, 103.

As a third step of the method, decompressing S3 the least one compressed data stream is performed by means of a data decompressor 401A, which is coupled to a data analysis module of a sensor network assembly.

The present invention provides a modified sensor-network-architecture that uses compression and decompression Units located throughout the entire sensor network.

The present invention the compression unit in terms of the data compressor 101A, 102A, 103A, wherein the compression unit compresses the data being output by sensor, for example, by removing the spatial and temporal redundancy in data.

The compressed data can be routed through vehicle network for
i) Online-data-streaming for visualizing the sensor data on the driver dash-board;
ii) Offline storage in car black-box or in data-recording-unit of car for later analysis; or
iii) Over-the-air transmission of data for data-analytics on the cloud

The decompression unit in terms of the data decompressor 401A will uncompressing the compressed data to provide following use cases
i) Online-data-streaming: for visualizing data on HMI devices or on car dashboard;
ii) Online-data-streaming: for processing of raw data on central ADCU (for any kind of raw data analysis); or
iii) Offline-data: here bandwidth consumption will be less when transmitting compressed data form.

According to an exemplary embodiment of the present invention, the compression unit supports both lossless and lossy modes, based on use case one can enable the required mode.

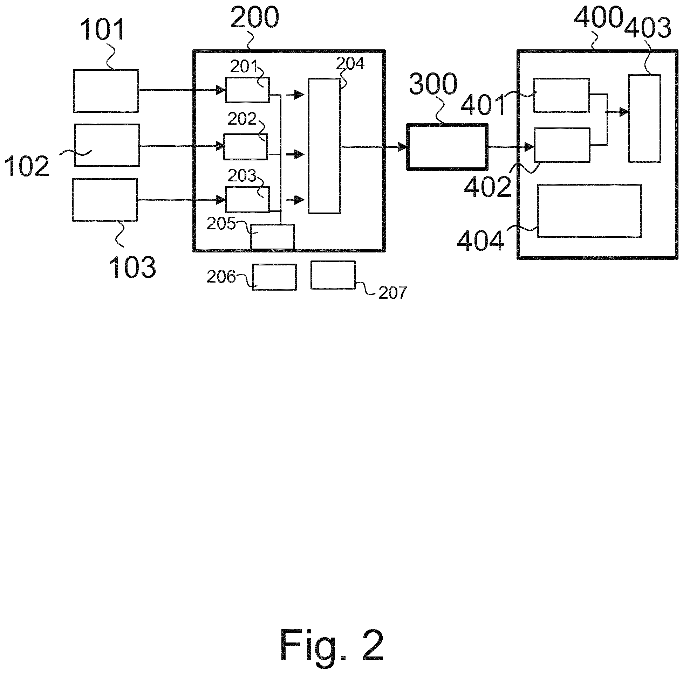

Fig. 2 shows a schematic diagram for the existing network sensor assembly without reducing the quantity of data for a vehicle for explaining the present invention.

The current architecture block diagram is shown in Fig. 2. In the existing systems the data acquisition unit (DAQ), i.e. sensors, captures data and this data is only transmitted, so there will be high probability of data redundancy, obviously there is need of removing redundancy to reduce data quantity.

For instance, a sensor 101 or a data acquisition unit is configured to provide at least one data stream. Further data stream providing entities, like further sensors 102 or vehicle bus interface 103 providing data streams may be implemented.

The data stream providing entities 101, 102, 103 provide their data streams to an MI4 recording box 200. The recording box 200 may comprise a time stamp provider 201, 202, 203, as well as a time master 205, further the recording box 200 may comprise a chronological history order module 204.

The recording box 200 may be coupled to a GPS antenna 206 and a disk drive 207 for data storage purpose.

The recording box 200 may be coupled to a Gbit Ethernet switch 300.

The Ethernet switch 300 is coupled to an analysis box module 400.

The analysis box module 400 may comprise an Ethernet device 402 and a sensor device module 401, data streams of both these devices are merged to a visualization box module 403.

The analysis box module 400 may comprise an analysis device 404 that preserves the recent history of the car data through the recording of dozens of parameters collected several times per second giving an accurate testimony, to assist in any later investigation.

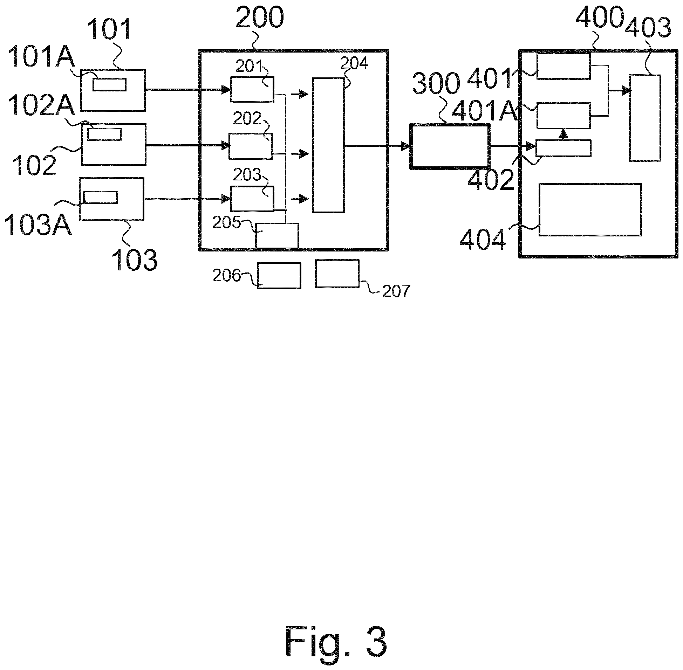

Fig. 3 shows a schematic diagram for a proposed network sensor assembly for reducing the quantity of data for a vehicle according to an exemplary embodiment of the present invention.

A sensor network assembly 100 for reducing quantity of data for vehicles comprises a data analysis module 400, at least one sensor 101, 102, 103, a data compressor 101A, 102A, 103A, and a data decompressor 401A.

The data analysis module 400 is configured to perform data analysis of input data.

The at least one sensor 101, 102, 103 is configured to provide at least one data stream.

The data compressor 101A, 102A, 103A is coupled to the at least one sensor 101, 102, 103 and is configured to compress the at least one data stream to provide at least one compressed data stream.

The data decompressor 401A is coupled to the data analysis module 400 and is configured to decompress the least one compressed data stream to provide the input data for algorithm analysis and/or for visualization.

According to an exemplary embodiment of the present invention, the network sensor assembly for reducing the quantity of data provides an embedded compression unit within each sensor unit and at least one decompression unit in the analysis box for visualization or data analytics (online or offline).

The compression unit removes redundancy and which saves the bandwidth consumption when transmitting data between the ECUs.

The advantages of the network sensor assembly are among others as follows:
1) High feasibility of embedding compression unit within in sensor, these sensors can be sold to customers along with compression unit, similar to IP-net cameras (in consumer electronic space).
2) Scalability of sensors.

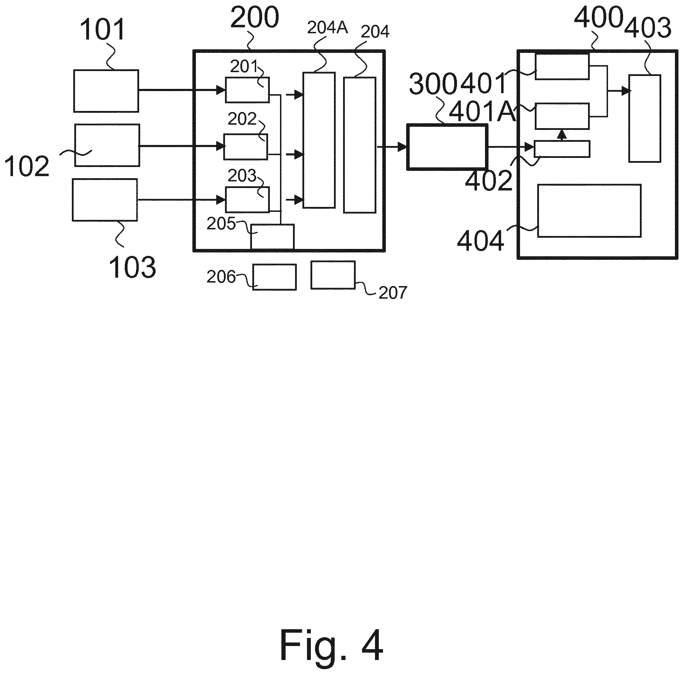

Fig. 4 shows a schematic diagram for a network sensor assembly for reducing the quantity of data for a vehicle according to an exemplary embodiment of the present invention.

A sensor network assembly 100 for reducing quantity of data for vehicles comprises a data analysis module 400, a data recording module 200, at least one sensor 101, 102, 103, a data compressor 204A, and a data decompressor 401A.

The data analysis module 400 is configured to perform data analysis of input data.

The data recording module 200 is configured to perform recording of data.

The at least one sensor 101, 102, 103 is configured to provide a data stream.

The data compressor 204A is coupled to the data recording module 200 and is configured to compress at least one data stream to provide at least one compressed data stream prior to the recording of the data.

The data decompressor 401A is coupled to a data analysis module 400 and is configured to decompress the least one compressed data stream.

According to an exemplary embodiment of the present invention, the network sensor assembly for reducing the quantity of data provides instead of embedding compression unit within sensors in analysis box as shown in Fig. 4, one compression unit is provided.

The centralized decompression unit remains in the analysis stage for further analysis purposes such as visualization.

The advantages of the network sensor assembly are among others as follows:
1) Bandwidth requirement of communication channel.
   a. In vehicle CAN network between ECUs.
   b. In wireless communication channel in V2V or V2I.
2) More vehicle data can be stored in given space, in the form of compressed data.
   a. Applicable for car-black box device to store large amounts of data in compressed form.
   b. Applicable for disk storage, which will be used for future algorithm's prototyping and development.

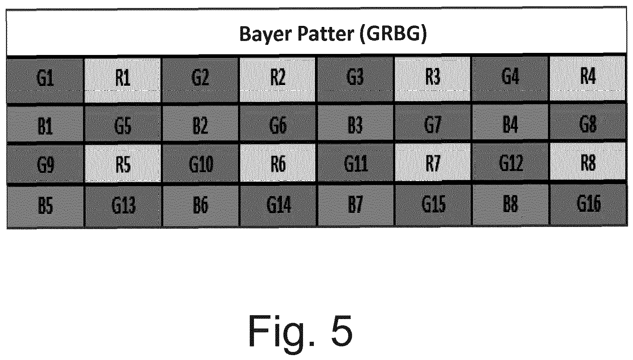

Fig. 5 shows an example Bayer pattern images captures by camera sensor according to an exemplary embodiment of the present invention.

According to an exemplary embodiment of the present invention, the network sensor assembly for reducing the quantity of data provides schemas for a camera based sensor, by embedding the proposed components compression unit within sensor.

The advantages of the network sensor assembly are achieving absolute lossless video compression (for all various camera specifications). This camera can be from front view or rear view or surround view. Here the challenges are:
1. Selection of best image/video coding standards such as JPEG2000 vs JPEG-LS vs MJPEG vs H.264 vs H.265 or any other standard.
2. Restructuring of data to ensure best use of the video coding concept
3. Choice of most optimal encoding parameters for our use case.

According to an exemplary embodiment of the present invention, the system starts with following steps for the selection of video coding standard:
For example, according to High Efficiency Video Coding (HEVC) standard, a restructuring of captured data is performed:
   A camera sensor captures Bayer pattern in the form of 12-bit-GRBG (Green, Red, Blue, Green) as shown below in Fig. 5.

As per the pattern, GREEN pixels are 2 times in number compared to RED and BLUE. The YUV 4:2:2 chromo sampling pattern is the best scheme for encoding this data content.

For instance of camera data compression point of view, we could see the advantages of the HEVC standard are:
1. Best known compression efficiency
2. High bit-depth encoding support (such as 12 -16 bit)
3. Support for various image sampling formats like YUV420, YUV422, YUV444, RGB24 etc.

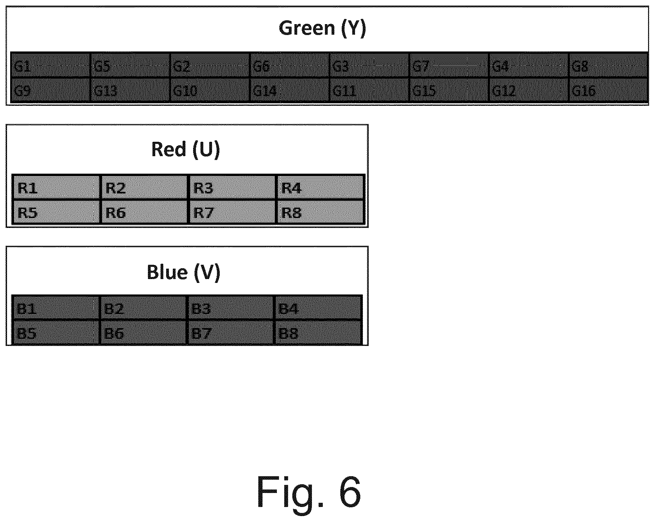

Fig. 6 shows a schematic diagram of data re-arrangement in YUV 4:2:2 chromo sampling according to an exemplary embodiment of the present invention.

The data is arranged as shown in Fig. 6 before feeding to the encoder. Thus there is no loss due to image format conversions.

Here we are well maintaining the spatial correlation within the frames as well temporal correlation between the frames of sequence, thus ensuring high compression efficiency.

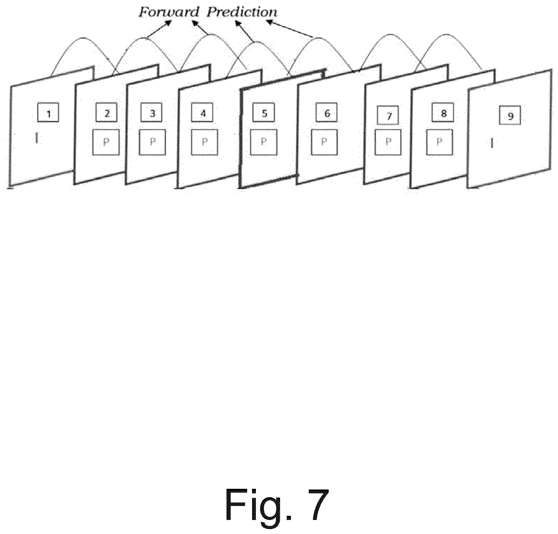

Fig. 7 shows a schematic diagram of a coding schema inside HEVC codec according to an exemplary embodiment of the present invention.

Choice of encoding parameters:
1. Lossless mode of data compression by using Quantization Parameter QP=4, which demonstrates no loss after encoding and decoding.
2. Group Of Picture coding schema as IPPPP i.e. only Intra (I) and Predictive coding (P), as shown in Fig. 7.
3. In automotive case, key frame (or I-Frames) inserted once in every 250 sequence of frames. (i.e. nothing but ∼ 8s, when capturing sequence at 30 frames per second)
4. Encoding preset is set to "very slow" mode in x265 library H.265 codec. This gives the best compression gains among all available presets in x265.

Higher compression gains can be achieved using lossy compression. Encoder settings for achieving this are same above, except that QP > 4. Loss can allowed without affecting the algorithm accuracy.

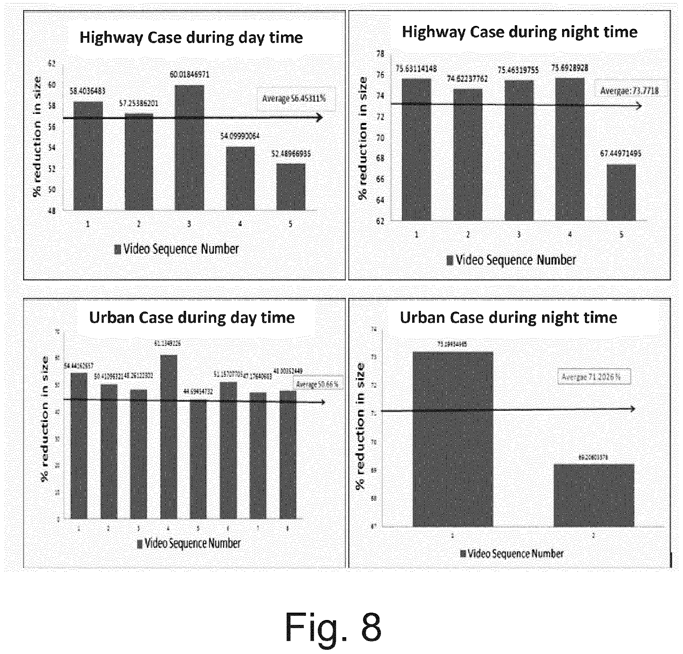

Fig. 8 shows a schematic diagram of results for a percentage reduction in size according to an exemplary embodiment of the present invention.

For the results for a percentage reduction in size as shown in Fig. 8, video sequences captured were analyzed according to the following parameters,
i) video sequences captured in urban environment and highways;
ii) video sequences captured during both day and night time;
iii) high textured images, and also flat surfaces;
iv) static vehicles on roads as well dynamic objects like pedestrians and vehicles; and
v) each sequence considered in this analysis has 100 to 400 frames captured at 30 fps.

The proposed system achieved 100% lossless data compression with the settings as mentioned.

The percentage reduction in size is achieved as follows:
i) average of 50% to 60 % during day time both in urban and highway scenarios; and
ii) Average of 70% to 75% in night scenario.

It has to be noted that embodiments of the present invention are described with reference to different subject-matters. In particular, some embodiments are described with reference to method type claims, whereas other embodiments are described with reference to the device type claims.

However, a person skilled in the art will gather from the above and the foregoing description that, unless otherwise notified, in addition to any combination of features belonging to one type of the subject-matter also any combination between features relating to different subject-matters is considered to be disclosed with this application.

However, all features can be combined providing synergetic effects that are more than the simple summation of these features.

While the invention has been illustrated and described in detail in the drawings and foregoing description, such illustration and description are to be considered illustrative or exemplary and not restrictive; the present invention is not limited to the disclosed embodiments.

Other variations to the disclosed embodiments can be understood and effected by those skilled in the art and practicing the claimed invention, from a study of the drawings, the disclosure, and the appended claims.

In the claims, the word "comprising" does not exclude other elements or steps, and the indefinite article "a" or "an" does not exclude a plurality. A single processor or controller or other unit may fulfill the functions of several items recited in the claims.

The mere fact that certain measures are recited in mutually different dependent claims does not indicate that a combination of these measures cannot be used to advantage. Any reference signs in the claims should not be considered as limiting the scope.

## Claims

1. A sensor network assembly (100) for reducing quantity of data for vehicles, the sensor network assembly (100) comprising:
- a data analysis module (400), which is configured to perform data analysis of input data;
- at least one sensor (101, 102, 103), which is configured to provide at least one data stream;
- a data compressor (101A, 102A, 103A), which is coupled to the at least one sensor (101, 102, 103) and which is configured to compress the at least one data stream to provide at least one compressed data stream; and
- a data decompressor (401A), which is coupled to the data analysis module (400) and which is configured to decompress the at least one compressed data stream to provide the input data.

2. The sensor network assembly (100) according to claim 1,
wherein the data compressor (101A, 102A, 103A) is configured to compress the at least one data stream by removing spatial redundancy and/or temporal redundancy of the at least one data stream.

3. The sensor network assembly (100) according to claim 1 or 2,
wherein the sensor network assembly (100) is configured to route the at least one compressed data stream through a vehicle based on:
- online-data-streaming for visualizing the at least one compressed data stream on a driver dash-board; and/or
- offline-data-streaming to a data storage of car black-box and/or to data-recording-unit of the car; and/or
- over-the-air transmission of the at least one compressed data stream for performing cloud-based data-analytics of the at least one compressed data stream.

4. The sensor network assembly (100) according to any one of the preceding claims,
wherein the data decompressor (401A) is configured to decompress the at least one compressed data stream to provide following use cases:
- online-data-streaming:
o for visualizing data on a human-machine-interface device or on driver dash-board; and/or
o for processing of the at least one compressed data stream on an assisted driving control unit; and/or
- offline-data-streaming:
o for reducing bandwidth consumption within the ECUs of vehicle network.

5. The sensor network assembly (100) according to any one of the preceding claims, wherein the data compressor (101A, 102A, 103A) is configured to support:
- lossless compression modes; and/or
- lossy compression modes.

6. The sensor network assembly (100) according to claim 5, wherein the data compressor (101A, 102A, 103A) is configured to switch between the supported lossless compression modes and the lossy compression modes based on an operation scenario.

7. The sensor network assembly (100) according to any one of the preceding claims,
wherein the sensor network assembly (100) is configured to be scalable to any number of sensors integrated into vehicle.

8. A sensor network assembly (100) for reducing quantity of data for vehicles, the sensor network assembly (100) comprising:
- a data analysis module (400), which is configured to perform data analysis of input data;
- a data recording module (200), which is configured to perform recording of data;
- at least one sensor (101, 102, 103), which is configured to provide a data stream;
- a data compressor (204A), which is coupled to the data recording module (200) and which is configured to compress at least one data stream to provide at least one compressed data stream prior to the recording of the data; and
- a data decompressor (401A), which is coupled to a data analysis module (400) and which is configured to decompress the least one compressed data stream.

9. The sensor network assembly (100) according to claim 8,
wherein the data compressor (204A) is configured to compress the at least one data stream by removing spatial redundancy and/or temporal redundancy of the least one data stream.

10. The sensor network assembly (100) according to claim 8 or 9,
wherein the sensor network assembly (100) is configured to route the at least one compressed data stream through a vehicle based on:
- online-data-streaming for visualizing the at least one compressed data stream on a driver dash-board; and/or
- offline-data-streaming to a data storage of car black-box and/or to data-recording-unit of the car; and/or
- over-the-air transmission of the at least one compressed data stream for performing cloud-based data-analytics of the at least one compressed data stream.

11. The sensor network assembly (100) according to any one of the preceding claims 8 to 10,
wherein the data decompressor (401A) is configured to decompress the least one compressed data stream to provide following use cases:
- online-data-streaming:
o for visualizing data on a human-machine-interface device or on driver dash-board; and/or
o for processing of the least one compressed data stream on an assisted driving control unit; and/or
- offline-data-streaming:
o for reducing bandwidth consumption.

12. A method for reducing quantity of data for vehicles, the method comprising the following steps of:
- Providing (S1) a data stream by means of at least one sensor (101, 102, 103);
- Compressing (S2) the at least one data stream to provide at least one compressed data stream by means of a data compressor (101A, 102A, 103A), which is coupled to the at least one sensor (101, 102, 103);
- Decompressing (S3) the least one compressed data stream by means of a data decompressor (401A), which is coupled to a data analysis module of a sensor network assembly.
